# EUROPEAN PATENT APPLICATION

(11) **EP 4 571 816 A1**
(43) Date of publication of application: **18.06.2025**
(21) Application number: 23216803.9
(22) Date of filing: 14.12.2023
(51) Int. Cl.: H01L 21/28, H01L 29/51, H01L 29/66, H10B 51/30, H10B 53/30

(54) **FERROELECTRIC DEVICE**

(71) Applicant: IMEC VZW, 3001 Leuven (BE)
(72) Inventor: POPOVICI, Mihaela Ioana, 3053 Haasrode (BE)
(74) Representative: Winger

(57) **Abstract**

A ferroelectric device (1, 10) comprising:
a hafnium zirconium oxide layer (2), doped with a redox-active metal cationic dopant and comprising an orthorhombic phase, and
a metal oxide layer (3), comprising an oxide of a redox-active metal cation, in physical contact with the hafnium zirconium oxide layer (2),
wherein the metal cationic dopant of the hafnium zirconium oxide layer (2) and the metal cation of the metal oxide layer (3) form a redox pair.

## Description

### Technical field of the invention

The present invention pertains to the field of ferroelectric devices, specifically to ferroelectric devices comprising a ferroelectric hafnium zirconium oxide layer.

### Background of the invention

The field of non-volatile memory technology is a critical area of research and development in the electronics industry. As devices become more sophisticated and the demand for higher performance and lower power consumption increases, there is a continuous push to improve memory technologies. Ferroelectric Random-Access Memory (FeRAM or FRAM) and Ferroelectric Field-Effect Transistors (FeFETs) are two types of non-volatile memory that have garnered significant interest due to their potential for high speed, low power consumption, and high endurance.

One of the materials that has shown promise in the development of FeRAM and FeFETs is hafnium zirconate (HZO). HZO is known for its compatibility with current semiconductor processes and its ability to maintain ferroelectric properties even when scaled down to thin films, which is essential for the miniaturization of electronic devices. The endurance of ferroelectric materials, which refers to the number of read/write cycles the material can withstand before its ferroelectric properties degrade, is a critical parameter for the practical application of these memories. For FeRAM, endurance levels beyond 1 E+12 cycles are desirable, while for FeFETs, endurance beyond 1E+9 cycles is sought.

However, there are several challenges associated with the use of HZO in ferroelectric memory applications. One of the main issues is the presence of multiple crystalline phases, such as tetragonal, orthorhombic, and monoclinic, with the orthorhombic phase being the desired phase for ferroelectric applications due to its high remanent polarization. Achieving and stabilizing the orthorhombic phase in HZO films is not straightforward and often requires careful control of the material's composition and processing conditions.

Another challenge is the phenomenon known as "wake-up," where the initial polarization of the ferroelectric material is relatively small and requires a number of electrical cycles before reaching its maximum value. This behaviour can be problematic for device performance and reliability, and, preferably, ferroelectric devices are wake-up-free.

Additionally, the introduction of dopants such as lanthanides (e.g., La, Y, Gd) has been explored to enhance the endurance of HZO. While doping with lanthanides can improve endurance, it does not necessarily address the issue of small initial polarization and the need for wake-up-free behaviour.

Despite the progress made in the development of HZO-based ferroelectric memories, there remains a need for further advancements in the field to address the challenges of phase stability, initial polarization, and wake-up behaviour without compromising the endurance of the material.

There is thus still a need in the art for devices and methods that address at least some of the above problems.

### Summary of the invention

It is an object of the present invention to provide a good ferroelectric device. It is a further object of the present invention to provide a good method of modifying an orthorhombic phase fraction in a hafnium zirconium oxide layer of the ferroelectric device.

The above objective is accomplished by a method and device according to the present invention.

In a first aspect, the present invention relates to a ferroelectric device comprising:
a hafnium zirconium oxide layer, doped with a redox-active metal cationic dopant and comprising an orthorhombic phase, and
a metal oxide layer, comprising an oxide of a redox-active metal cation, in physical contact with the hafnium zirconium oxide layer,
wherein the metal cationic dopant of the hafnium zirconium oxide layer and the metal cation of the metal oxide layer form a redox pair.

In a second aspect, the present invention relates to a method of forming a ferroelectric device in accordance with embodiments of the first aspect of the present invention, the method comprising:
i) providing an intermediate in the formation of the ferroelectric device comprising:
   the hafnium zirconium oxide layer, doped with a redox-active dopant and comprising a tetragonal phase, and
   a metal oxide layer, comprising an oxide of a redox-active metal, in physical contact with the hafnium zirconium oxide layer,
   wherein the dopant and the metal form a redox pair, then
ii) inducing a reduction of the metal of the metal oxide layer, so as to transfer oxygen from the metal oxide layer into the hafnium zirconium oxide layer, thereby converting at least part of said tetragonal phase into an orthorhombic phase.

In a third aspect, the present invention relates to an intermediate in the formation of a ferroelectric device comprising:
a hafnium zirconium oxide layer, doped with a redox-active dopant and comprising a tetragonal phase, and
a metal oxide layer, comprising an oxide of a redox-active metal, in physical contact with the hafnium zirconium oxide layer,
wherein the dopant and the metal form a redox pair.

In a fourth aspect, the present invention relates to a non-volatile memory device comprising a memory cell array, wherein at least one memory cell in the memory cell array comprises a ferroelectric device according to any embodiments of the first aspect of the present invention.

It is an advantage of embodiments of the present invention that the ferroelectric device may exhibit enhanced endurance, surpassing 1 E+12 cycles for ferroelectric random-access memory (FERAM) applications and 1 E+9 cycles for ferroelectric field-effect transistor (FEFET) applications. It is a further advantage of embodiments of the present invention that the ferroelectric device may maintain high remanent polarization, which is advantageous for memory applications. It is an additional advantage of embodiments of the present invention that the stabilization of the orthorhombic phase in hafnium zirconate (HZO) may be controlled through the use of multi-oxidation state dopants. It is yet another advantage of embodiments of the present invention that the ferroelectric response may be enhanced, with polarization values exceeding 30µC/cm².

It is an advantage of embodiments of the present invention that the wake-up behaviour of the ferroelectric device can be minimized, requiring fewer than 1000 cycles to reach near-maximum polarization values under an applied electrical field. It is a further advantage of embodiments of the present invention that the transition from the orthorhombic to the monoclinic phase, which typically occurs after a high number of cycles, may be impeded by the presence of the redox-active metal cationic dopant. It is an advantage of embodiments of the present invention that the ferroelectric device can be constructed with a redox-active metal cationic dopant and a metal oxide layer comprising an oxide of a redox-active metal cation, forming a redox pair that enables a redox reaction under an applied electrical field or thermal treatment. This reaction prevents filling of oxygen vacancies in the hafnium zirconium layer, thereby preventing conversion of the ferroelectric orthorhombic phase into a non- ferroelectric monoclinic phase.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable, and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 is a schematic representation of a ferroelectric capacitor in accordance with embodiments of the present invention.
Fig. 2 is a schematic representation of a ferroelectric field effect transistor in accordance with embodiments of the present invention.
Fig. 3 to 7 are schematic representations of a structure in subsequent steps of a method for forming of a ferroelectric device in accordance with embodiments of the present invention.
FIG. 8 is a schematic representation of a perspective view of a non-volatile memory device comprising a memory cell array in accordance with embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", also used in the claims, should not be interpreted as being restricted to the means listed thereafter; it does not exclude other elements or steps. It is thus to be interpreted as specifying the presence of the stated features, integers, steps, or components as referred to, but does not preclude the presence or addition of one or more other features, integers, steps or components, or groups thereof. Thus, the scope of the expression "a device comprising means A and B" should not be interpreted as being limited to devices consisting only of components A and B. It means that with respect to the present invention, the only relevant components of the device are A and B. The term "comprising" therefore covers the situation where only the stated features are present and the situation where these features and one or more other features are present. The word "comprising" according to the invention therefore also includes as one embodiment that no further components are present. When the word "comprising" is used to describe an embodiment in this application, it is to be understood that an alternative version of the same embodiment, wherein the term "comprising" is replaced by "consisting of", is also encompassed within the scope of the present invention.

Similarly, it is to be noticed that the term "coupled" should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of a deviceembodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures, and techniques have not been shown in detail in order not to obscure an understanding of this description.

The following terms are provided solely to aid in the understanding of the invention.

As used herein, and unless otherwise specified, the term "ferroelectric device" refers to a device comprising a component that exhibits ferroelectricity, which is the property of having a spontaneous electric polarization that can be reversed by the application of an external electric field. Specific embodiments of ferroelectric devices include, but are not limited to, ferroelectric capacitors and ferroelectric transistors.

As used herein, and unless otherwise specified, the term "redox pair" refers to a combination of two species, one of which can donate electrons (reduced form) and the other can accept electrons (oxidized form) during a redox reaction. In the context of the ferroelectric device, the redox pair is formed by the metal cationic dopant in the hafnium zirconium oxide layer and the metal cation in the metal oxide layer. For example, a redox pair may be formed by, on one hand, a first type of cation selected from: W²⁺, W³⁺ or W⁴⁺, Cr²⁺ or Cr³⁺, Ce³⁺, V²⁺,V³⁺, or V⁴⁺ and Mo²⁺ ,Mo³⁺or Mo⁴⁺; and on another hand, a second type of cation selected from: W⁵⁺ or Vif³⁺, Mo⁵⁺ or Mo⁶⁺, V⁵⁺ , Ce⁴⁺ and Cr⁵⁺ or Cr⁶⁺. An electron transfer may, in that case, occur from the second type of cation, which is in a high oxidation state and may be easily reduced, to the first type of cation, which is in a low oxidation state and may be easily oxidized. Typically, no redox pair is formed between a first type of cation and another first type of cation, which may be both easily oxidized but not easily reduced. Typically, no redox pair is formed between a second type of cation and another second type of cation, which may be both easily reduced but not easily oxidized.

As used herein, and unless otherwise specified, the term "at.-%" refers to atomic percent, which is a measure of concentration expressed as the number of atoms of a particular element divided by the total number of atoms in the mixture, multiplied by 100. The atomic percentage may be as determined using Rutherford Backscattering Spectroscopy.

As used herein, and unless otherwise specified, the term "orthorhombic phase fraction" refers to the proportion of the hafnium zirconium oxide layer that exists in the orthorhombic crystal structure, which is one of the possible phases of hafnium zirconium oxide that can exhibit ferroelectric properties. Modifying the orthorhombic phase fraction can influence the ferroelectric characteristics of the layer. In particular, increasing the orthorhombic phase fraction may improve the ferroelectric characteristics of the layer.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In a first aspect, the present invention relates to a ferroelectric device comprising:
a hafnium zirconium oxide layer, doped with a redox-active metal cationic dopant and comprising an orthorhombic phase, and
a metal oxide layer, comprising an oxide of a redox-active metal cation, in physical contact with the hafnium zirconium oxide layer,
wherein the metal cationic dopant of the hafnium zirconium oxide layer and the metal cation of the metal oxide layer form a redox pair.

In embodiments, the concentration of the dopant in the hafnium zirconium oxide layer may be from 0.5 to 4.5 at.-%, preferably from 1.5 to 3.5 at.-%. These embodiments may provide good durability of an orthorhombic phase fraction of the hafnium zirconium oxide layer for retaining the ferroelectric properties of hafnium zirconium oxide.

In embodiments, the thickness of the hafnium zirconium oxide layer may be from 1 nm to 20 nm, for example, from 5 nm to 10 nm.

In embodiments, the thickness of the metal oxide layer may be from 0.5 nm to 5 nm, for example, from 1 nm to 3 nm.

In embodiments, the dopant may be selected from tungsten, chromium, cerium, vanadium, niobium, and molybdenum. These dopants may switch between a plurality of oxidation states, thereby providing good durability of the orthorhombic phase fraction.

In embodiments, the hafnium zirconium oxide layer may, in addition to the redox-active metal cationic dopant, be doped with a lanthanide such as lanthanum. Lanthanide, and in particular lanthanum, may provide oxygen vacancies in the hafnium zirconium oxide layer. Lanthanides are typically not redox-active.

In embodiments, the metal cation of the metal oxide layer may comprise at least one of chromium, tungsten, vanadium, and molybdenum, wherein, when the metal cation comprises chromium, the metal oxide layer also comprises tungsten, molybdenum, or vanadium. In embodiments, the metal oxide layer may comprise at least one of Cr_{2-y}W_{y}Oₓ, Cr_{2-y}Mo_{y}Oₓ, Cr_{2-y}V_{y}Oₓ, W₂O_{×}, Mo₂Oₓ, and V₂O_{(5/6)x}, such as Cr_{2-y}W_{y}O₆, Cr_{2-y}Mo_{y}O₆, Cr_{2-y}V_{y}O_{6-y/2}, WO₃, MoO₃, and V₂O₅, with 0.0 < y < 2.0 and 0.0 < x ≤ 6.0, e.g., with 0.0 < y < 2.0 and 2.0 ≤ x ≤ 6.0.

The metal cation of the metal oxide layer may be provided in a high oxidation state when it is deposited. Therefore, in an intermediate in the formation of the device, wherein the hafnium zirconium oxide layer may comprise a large tetragonal phase fraction (i.e., a large amount of oxygen vacancies), the metal cation may be easily reduced and used to reduce the number of oxygen vacancies in the hafnium zirconium oxide layer, thereby inducing a conversion in the hafnium zirconium oxide layer of the tetragonal phase to the orthorhombic phase and forming the device.

In embodiments, the metal cationic dopant of the hafnium zirconium oxide layer and the metal cation of the metal oxide layer forming a redox pair means that a redox reaction may take place between the metal cationic dopant and the metal cation. In said redox reaction, one of the metal cationic dopants and the metal cation may be reduced, while another of the metal cationic dopant and the metal cation may be oxidized. In said redox reaction, an oxygen atom may be released by said one of the metal cationic dopants and the metal cation, while the other of the metal cationic dopant and the metal cation may receive said oxygen atom. Typically, during voltage cycling of the device, the metal cation may be reduced while the metal cationic dopant may be oxidized. In that case, the redox pair may be adapted so that the metal cation may be reduced and the metal cationic dopant may be the oxidized in a redox reaction between the metal cationic dopant and the metal cation.

When a voltage is applied to the metal oxide layer, e.g., during voltage cycling that is inherent in functioning of the device, the metal cation of the metal oxide layer may be reduced, releasing oxygen that may be transferred into the hafnium zirconium oxide layer. Without being bound by theory, the oxygen may fill oxygen vacancies in the hafnium zirconium oxide layer. Thereby, the amount of oxygen vacancies in the hafnium zirconium oxide layer may be reduced, so that, in turn, the orthorhombic phase fraction in the hafnium zirconium oxide layer may be reduced. Indeed, the phase of the hafnium zirconium oxide layer may depend on the amount of oxygen vacancies in the hafnium zirconium oxide layer. When the amount of oxygen vacancies is low, the hafnium zirconium oxide layer may be predominantly in a monoclinic phase. When the amount of oxygen vacancies is high, the hafnium zirconium oxide layer may be predominantly in a tetragonal phase. When the amount of oxygen vacancies is intermediate, the hafnium zirconium oxide layer may be predominantly in an orthorhombic phase, which is the preferred phase as it is the ferroelectric phase.

Said redox reaction wherein oxygen binds to the redox active dopants may prevent that the oxygen fills the oxygen vacancies. Thereby, modification of the amount of oxygen vacancies in the hafnium zirconium oxide layer may be prevented, so that conversion of the orthorhombic phase fraction in the hafnium zirconium oxide layer into the monoclinic phase may be prevented.

The ferroelectric device may comprise a controller. Said controller may be for performing the functions of the device. In particular, said controller may be configured for applying a voltage to the metal oxide layer and/or to the hafnium zirconium oxide layer, i.e., during voltage cycling when the device is in function.

In embodiments, the ferroelectric device may be a ferroelectric capacitor or a ferroelectric transistor.

In embodiments, the ferroelectric device may be a ferroelectric capacitor, wherein the hafnium zirconium oxide layer is provided over a bottom electrode layer and under a top electrode layer. This embodiment advantageously provides a structure that is suitable for integration into capacitor-based memory and logic devices.

In embodiments, the ferroelectric device may be a ferroelectric field-effect transistor, wherein the hafnium zirconium oxide layer and the metal oxide layer are provided above a channel and below a top electrode layer. This embodiment advantageously provides a structure that is suitable for integration into transistor-based memory and logic devices.

In embodiments, the metal oxide layer may be in physical contact with at least one of the electrodes and with the hafnium zirconium oxide layer. This embodiment advantageously ensures effective interaction between the layers for enhanced redox activity and device performance.

In embodiments, an interfacial layer comprising TiO₂, MoOₓ, HfO₂, ZrO₂, Cr₂WO₆, Cr₂MoO₆, Cr₂VO₆, V₂O₅ or WO₃, wherein x is from 2 to 3, may be present between the bottom or top electrode layer and the hafnium zirconium oxide layer, wherein the interfacial layer is in physical contact with the hafnium zirconium oxide layer on the side where the metal oxide layer is not present. The interfacial layer may provide the hafnium zirconium oxide layer with larger grains and a favorable grain orientation. Furthermore, the interfacial layer may induce large tensile stress into the hafnium zirconium oxide layer, which may result in a large remanent polarization.

In embodiments, the thickness of the interfacial layer may be from 0.5 nm to 5 nm, for example, from1nm to 3 nm.

Any features of any embodiment of the first aspect may be independently as correspondingly described for any embodiment of any other aspect of the present invention.

In a second aspect, the present invention relates to a method of forming a ferroelectric device in accordance with embodiments of the first aspect of the present invention, the method comprising:
i) providing an intermediate in the formation of the ferroelectric device comprising:
   the hafnium zirconium oxide layer, doped with a redox-active dopant and comprising a tetragonal phase, and
   a metal oxide layer, comprising an oxide of a redox-active metal, in physical contact with the hafnium zirconium oxide layer,
   wherein the dopant and the metal form a redox pair, then
ii) inducing a reduction of the metal of the metal oxide layer, so as to transfer oxygen from the metal oxide layer into the hafnium zirconium oxide layer, thereby converting at least part of said tetragonal phase into an orthorhombic phase.

In embodiments, step ii may comprise applying a thermal treatment to the metal oxide layer. In embodiments, applying the thermal treatment may comprise heating the intermediate to a temperature of from 100°C to 600°C, preferably from 300°C to 400°C. This embodiment advantageously allows for the activation of the reduction of the metal of the metal oxide layer through thermal energy, which may be applied when crystallizing the hafnium zirconium oxide layer. For example, the thermal treatment may be part of a crystallization anneal of the hafnium zirconium oxide layer. The thermal treatment may be applied in an oven.

In embodiments, step ii may comprise applying a voltage to the metal oxide layer. Said applying of the voltage may comprise voltage cycling, which may be inherent in functioning of the device. This embodiment advantageously allows for the activation of the reduction of the metal of the metal oxide layer through electrical energy, which can be precisely controlled. Said voltage may be applied via an electrode layer, e.g., the bottom or top electrode layer, electrically coupled to or in physical contact with the metal oxide layer. Said voltage may be applied, e.g., to said electrode layer or directly to the metal oxide layer, by a controller.

In embodiments, the metal oxide layer may be provided by depositing the metal by physical vapor deposition, then applying an oxidizing plasma so as to oxidize the deposited metal. This embodiment advantageously provides a method for forming the metal oxide layer with a controlled oxidation state. Alternatively, the metal oxide layer could be deposited directly by atomic layer deposition. Still alternatively, the metal oxide layer could be deposited directly by physical vapor deposition. In these embodiments, the oxidizing plasma may not be required.

In embodiments, the metal oxide layer may be provided by atomic layer deposition. This embodiment advantageously allows for precise control over the thickness and composition of the metal oxide layer.

In embodiments, providing the hafnium zirconium oxide layer doped with a dopant may comprise performing atomic layer deposition. This embodiment advantageously allows for precise control over the doping process and the resulting ferroelectric properties.

In embodiments, providing the hafnium zirconium oxide layer doped with a dopant may comprise depositing, alternatingly:
a sublayer of hafnium zirconium oxide, and
a sublayer of an oxide of the dopant.
After depositing the sublayers, an anneal, for example, at a temperature of from 350 to 600 °C, may be performed so that the sublayers form a crystalline hafnium zirconium oxide layer. In embodiments, each of the sublayers of hafnium zirconium oxide may have a thickness of at most 10 nm, e.g., at most 2 nm, or at least 1 nm. Each of the sublayers of an oxide of the dopant may have a thickness of at most 10 nm, e.g., at most 2 nm, or at least 1 nm. In embodiments, said alternatingly depositing may further comprise depositing sublayers of a lanthanide oxide such as lanthanum oxide. These sublayers may be deposited alternatingly with the sublayers of hafnium zirconium oxide, and/or the sublayers of an oxide of the dopant. In embodiments, each of the sublayers of the lanthanide oxide may have a thickness of at most 1 nm, e.g., at most 0.5 nm, or at least 0.1 nm.

In embodiments, depositing the sublayer of an oxide of the dopant may comprise depositing at least one of WOₓ, CrOₓ, CeOₓ, NbOₓ, VOₓ, and MoOₓ, with x from 1.0 to 1.5. By providing the dopant in a low oxidation state, the dopant may be easily oxidized, so that oxygen injected from the metal oxide layer in the hafnium zirconium oxide layer may react with the dopant instead of filling oxygen vacancies. In the device, the dopant may prevent a reduction of the number oxygen vacancies in the orthorhombic phase, and thus prevent converting the (ferroelectric) orthorhombic phase of the hafnium zirconium oxide layer into a (non-ferroelectric) monoclinic phase.

Although said redox active dopant may prevent a conversion of the orthorhombic phase into the monoclinic phase, the conversion of the tetragonal phase into the orthorhombic phase in step ii may still proceed due to very low activation energy of tetragonal to orthorhombic phase transition. Indeed, the number of oxygen vacancies is large when the hafnium zirconium oxide layer is in the tetragonal phase, so that the rate of filling the oxygen vacancies with oxygen is large even in presence of the redox active dopant.

Any features of any embodiment of the second aspect may be independently as correspondingly described for any embodiment of any other aspect of the present invention.

In a third aspect, the present invention relates to an intermediate in the formation of a ferroelectric device comprising:
a hafnium zirconium oxide layer, doped with a redox-active dopant and comprising a tetragonal phase, and
a metal oxide layer, comprising an oxide of a redox-active metal, in physical contact with the hafnium zirconium oxide layer,
wherein the dopant and the metal form a redox pair.

Any features of any embodiment of the third aspect may be independently as correspondingly described for any embodiment of any other aspect of the present invention.

In a fourth aspect, the present invention relates to a non-volatile memory device comprising a memory cell array, wherein at least one memory cell in the memory cell array comprises a ferroelectric device according to any embodiments of the first aspect of the present invention. In embodiments, the ferroelectric device may be a ferroelectric capacitor, which may function as a ferroelectric random-access memory cell. In embodiments, the ferroelectric device may be a ferroelectric field-effect transistor, which may function as a ferroelectric field-effect transistor memory cell.

Any features of any embodiment of the fourth aspect may be independently as correspondingly described for any embodiment of any other aspect of the present invention.

### Example 1: Ferroelectric capacitor

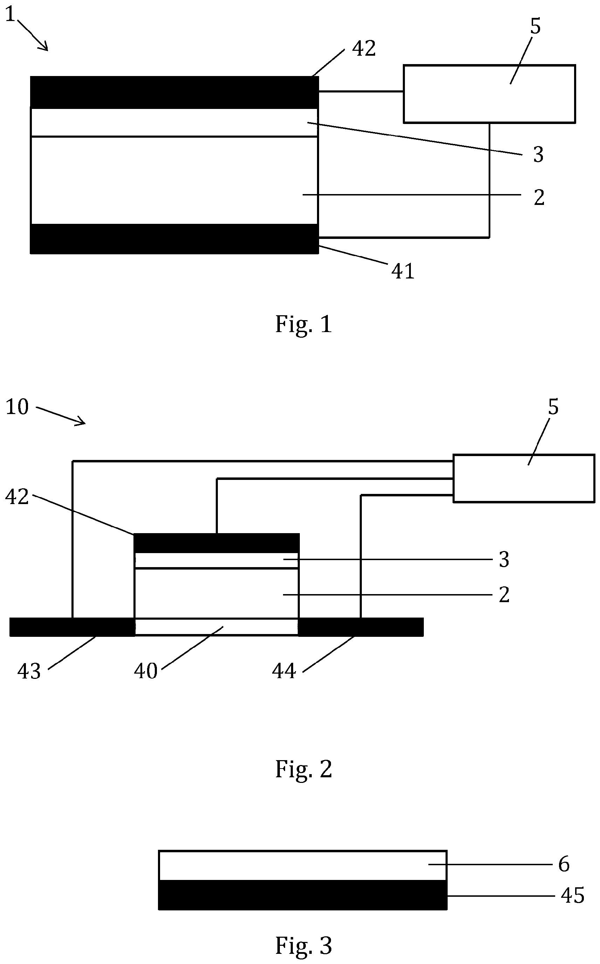

We now refer to Fig. 1, which is a schematic cross-sectional view of a ferroelectric device (1), in particular, a ferroelectric capacitor (1), according to embodiments of the present invention. The device (1) includes a hafnium zirconium oxide layer (2), doped with a redox-active metal cationic dopant, and a metal oxide layer (3), comprising an oxide of a redox-active metal cation, in physical contact with the hafnium zirconium oxide layer (2). The metal cationic dopant of the hafnium zirconium oxide layer (2) and the metal cation of the metal oxide layer (3) form a redox pair.

The hafnium zirconium oxide layer (2) and the metal oxide layer (3) are located over a bottom electrode layer (41) and below a top electrode layer (42). In the present example, the metal oxide layer (3) is located above the hafnium zirconium oxide layer (2) and below the top electrode layer (42). The metal oxide layer (3) electrically contacts the top electrode layer (42).

Alternatively, the metal oxide layer (3) could be located below the hafnium zirconium oxide layer (2) and above the bottom electrode layer (41), in which case the metal oxide layer (3) could electrically contact the bottom electrode layer (41).

Still alternatively, although the present example contains a single metal oxide layer (3), the device (1) could comprise a further metal oxide layer, which could be located between the bottom electrode layer (41) and the hafnium zirconium oxide layer (2). The further metal oxide layer may physically contact the hafnium zirconium oxide layer (2). The further metal oxide layer may physically contact the bottom electrode layer (41).

The hafnium zirconium oxide layer (2) comprises an orthorhombic phase.

A voltage may be applied to the metal oxide layer (3) via the electrode contacting the metal oxide layer (3), which is in the present example the top electrode layer (42). Said voltage may, for example, be voltage cycling, applied during use of the device (1). Said applied voltage may reduce the metal cation of the metal oxide layer (3). Thereby, oxygen atoms may be released or transferred, from the metal oxide layer (3) into the hafnium zirconium oxide layer (2). The oxygen atoms may fill oxygen vacancies in the hafnium zirconium oxide layer (2), so that the amount of oxygen vacancies in the hafnium zirconium oxide layer (2) may be reduced. When the amount of oxygen vacancies becomes low, the orthorhombic phase of the hafnium zirconium oxide layer (2) may convert into a monoclinic phase.

The redox-active metal cationic dopant, forming a redox pair with the metal cation of the metal oxide layer (3), may react with the oxygen atoms. Thus, the dopant may prevent that the oxygen atoms fill the oxygen vacancies of the hafnium zirconium oxide layer (2), and may, therefore, prevent said conversion of the orthorhombic phase into the monoclinic phase.

The voltage may be applied by a controller (5), which is, in this example, electrically coupled to the bottom electrode layer (41) and to the top electrode layer (42).

### Example 2: Ferroelectric field effect transistor

Reference is made to Fig. 2, which is a schematic cross-sectional view of a ferroelectric device (10), in particular, a ferroelectric field effect transistor (10), according to embodiments of the present invention. The device (10) includes a hafnium zirconium oxide layer (2), doped with a redox-active metal cationic dopant, and a metal oxide layer (3), comprising an oxide of a redox-active metal cation, in physical contact with the hafnium zirconium oxide layer (2). The metal cationic dopant of the hafnium zirconium oxide layer (2) and the metal cation of the metal oxide layer (3) form a redox pair.

The hafnium zirconium oxide layer (2) and the metal oxide layer (3) are located over a channel (40) and below a top electrode layer (42). The channel (40) may be a semiconductor channel, such as an oxide semiconductor channel. The channel (40) is located between a source (43) and a drain (44). In the present example, the metal oxide layer (3) is located above the hafnium zirconium oxide layer (2) and below the top electrode layer (42).

The ferroelectric device (10) comprises a controller (5). The controller (5) is electrically coupled to the top electrode layer (42), to the source (43) and to the drain (44).

Said controller (5) may be configured for applying a voltage, i.e., during voltage cycling, to the top electrode layer (42), which may induce a change to the oxidation state of a redox-active metal cation of the metal oxide layer (3). Said application of the voltage may be part of the operation of the device (10), e.g., for opening of the gate or sending current through the channel.

As described above, in particular, reduction of the redox-active metal cation of the metal oxide layer (3) may result in the transfer of oxygen atoms from the metal oxide layer (3) into the hafnium zirconium oxide layer (2). The redox-active metal cationic dopant may react with the oxygen atoms and prevent that oxygen vacancies in the hafnium zirconium oxide layer (2) could be filled. This may prevent conversion of an orthorhombic phase of the hafnium zirconium oxide layer (2), into a monoclinic phase, which would occur if the amount of oxygen vacancies becomes low.

### Example 3: Forming a ferroelectric device

Now, a method, in accordance with embodiments of the present invention, of forming a ferroelectric device in accordance with embodiments of the present invention is described.

Reference is made to Fig. 3. A substrate (45) is provided. The composition of the substrate (45) may depend on the type of ferroelectric device that is to be formed. The substrate (45) may comprise a bottom electrode when the method is for forming a ferroelectric capacitor. The substrate (45) may be a channel or comprise a channel material when the method is for forming a ferroelectric field effect transistor.

In this example, an interfacial layer (6) is provided over the substrate (45). The interfacial layer (6) may have a positive influence on the growth of a hafnium zirconium oxide layer.

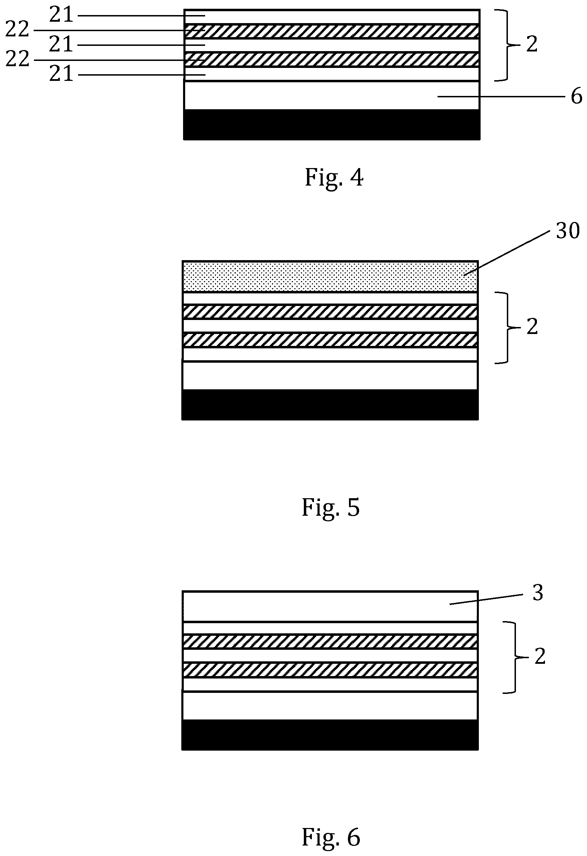

Reference is made to Fig. 4. A hafnium zirconium oxide layer (2) is provided over the interfacial layer (6). In this example, providing the hafnium zirconium oxide layer (2) doped with a dopant comprises depositing, alternatingly: a sublayer (21) of hafnium zirconium oxide, and a sublayer (22) of an oxide of the dopant. Furthermore, sublayers of a lanthanide oxide such as lanthanum oxide could be deposited, alternatingly with the sublayers (21) of hafnium zirconium oxide, and/or the sublayers (22) of an oxide of the dopant.

Reference is made to Fig. 5. A metal oxide layer is formed on the hafnium zirconium oxide layer (2), in physical contact therewith. In this example, to form the metal oxide layer, first, the metal (30) for the metal oxide layer is deposited by physical vapor deposition.

Reference is made to Fig. 6. Subsequently, an oxidizing plasma is applied to the metal so as to oxidize the deposited metal. Thereby, the metal oxide layer (3) is formed on, i.e., in physical contact with, the hafnium zirconium oxide layer (2).

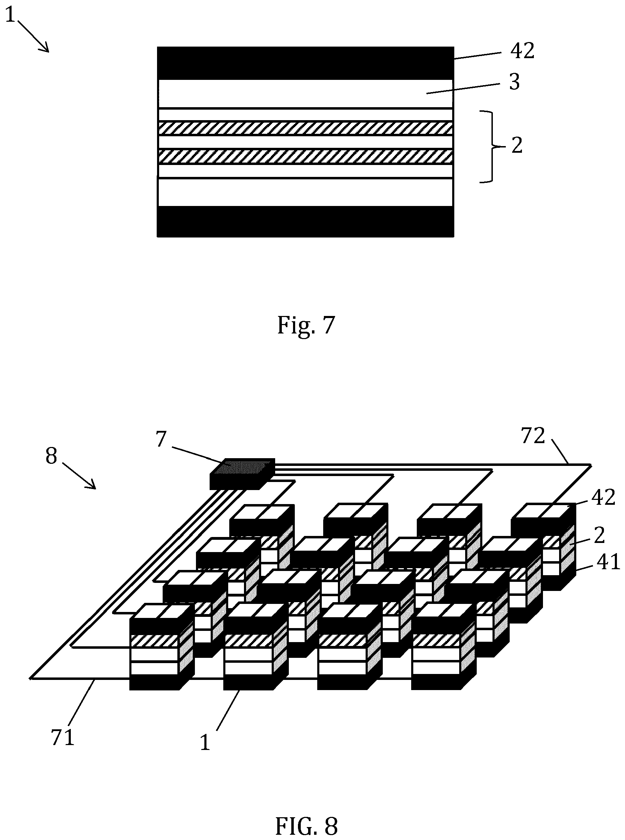

Reference is made to Fig. 7. Subsequently, a top electrode layer (42) may be deposited over, e.g., on the metal oxide layer (3), electrically coupled to the metal oxide layer (3).

The deposited hafnium zirconium oxide layer (2) may comprise a large tetragonal phase fraction due to the present of a large amount of oxygen vacancies. A crystallization anneal may be performed, subsequently, for further crystallization of the hafnium zirconium oxide layer (2). The crystallization anneal may be applied to convert tetragonal crystallites into a crystalline orthorhombic phase. Furthermore, the crystallization anneal may convert an amorphous phase fraction of the hafnium zirconium oxide layer (2) that may be present, into a crystalline orthorhombic phase (typically via a transition through the tetragonal phase). Herein, the crystallization anneal may result in the release and transfer of oxygen atoms from the metal oxide layer (3) into the hafnium zirconium oxide layer (2), thereby sufficiently filling oxygen vacancies in the hafnium zirconium oxide layer (2) so as to convert at least part of the (non-ferroelectric) tetragonal phase fraction into a (ferroelectric) orthorhombic phase fraction, thereby forming the ferroelectric device (1).

### Example 4: Non-volatile memory device

Reference is made to FIG. 8, which is a non-volatile memory device (8) comprising a memory cell array in accordance with embodiments of the present invention.

In this example, each memory cell in the memory cell array comprises a ferroelectric device (1) that is a ferroelectric capacitor (1) in accordance with embodiments of the present invention. Each ferroelectric capacitor (1) may function as a ferroelectric random access memory cell. Each ferroelectric capacitor (1) of the present example may have features that are the same as the ferroelectric capacitor of Example 1 as detailed above.

The non-volatile memory device (8) further comprises a controller (7), which may be a processor. The controller (7) may be electrically coupled to row lines (71) for addressing rows of ferroelectric capacitors (1). Herein, each row line (71) may be connected to the bottom electrode layer (41) of each ferroelectric capacitor (1) in a row of the memory cell array. The controller (7) may be electrically coupled to column lines (72) for addressing columns of ferroelectric capacitors (1). Herein, each column line (72) may be connected to the top electrode layer (42) of each ferroelectric capacitor (1) in a column of the memory cell array. Similarly, as in memory cells of the state of the art, each ferroelectric capacitor (1) may be individually read or written by providing a voltage to the row line (71) and to the column line (72) electrically connected to the ferroelectric capacitor (1).

Although in the illustrated example, the non-volatile memory device (8) further comprises memory cells that are ferroelectric capacitors (1), instead, the memory cells may comprise ferroelectric field-effect transistors.

The ferroelectric hafnium zirconium oxide layer (2) in accordance with embodiments of the present invention may have a high polarization of remanent polarization and a high endurance. Therefore, the ferroelectric devices (1) in accordance with embodiments of the present invention may provide the non-volatile memory device (8) with improved properties for retaining binary data written to the memory cells, i.e., to the ferroelectric capacitors (1), of the memory cell array.

It is to be understood that although preferred embodiments, specific constructions, and configurations, as well as materials, have been discussed herein for devices according to the present invention, various changes or modifications in form and detail may be made without departing from the scope of this invention. Steps may be added or deleted to methods described within the scope of the present invention.

## Claims

1. A ferroelectric device (1, 10) comprising:
a hafnium zirconium oxide layer (2), doped with a redox-active metal cationic dopant and comprising an orthorhombic phase, and
a metal oxide layer (3), comprising an oxide of a redox-active metal cation, in physical contact with the hafnium zirconium oxide layer (2),
wherein the metal cationic dopant of the hafnium zirconium oxide layer (2) and the metal cation of the metal oxide layer (3) form a redox pair.

2. The ferroelectric device (1, 10) of claim 1, wherein a concentration of the dopant in the hafnium zirconium oxide layer (2) is from 0.5 to 4.5 at.-%, preferably from 1.5 to 3.5 at.-%.

3. The ferroelectric device (1, 10) of claim 1 or 2, wherein the dopant is selected from tungsten, chromium, cerium, vanadium, niobium, and molybdenum.

4. The ferroelectric device (1, 10) of any of the previous claims, wherein the metal cation of the metal oxide layer (3) comprises at least one of chromium, tungsten, vanadium, and molybdenum, wherein, when the metal cation comprises chromium, the metal oxide layer also comprises tungsten, molybdenum, or vanadium.

5. The ferroelectric device (1, 10) of claim 4, wherein the metal oxide layer (3) comprises at least one of Cr_{2-y}W_{y}Oₓ, Cr_{2-y}Mo_{y}Oₓ, Cr_{2-y}V_{y}Oₓ, \N₂Oₓ, Mo₂O_{×}, and V₂O₍₅₆₎ₓ, with 0.0 < y < 2.0, and 0.0 < x ≤ 6.0.

6. The ferroelectric device (1, 10) of any of the previous claims, wherein the ferroelectric device (1, 10) is a ferroelectric capacitor (1) or a ferroelectric transistor (10).

7. The ferroelectric device (1) of claim 6, wherein the ferroelectric device (1) is a ferroelectric capacitor (1), wherein the hafnium zirconium oxide layer (2) is provided over a bottom electrode layer (41) and under a top electrode layer (42).

8. The ferroelectric device (1) of claim 7, wherein the metal oxide layer (3) is in physical contact with at least one of the electrodes (41, 42) and with the hafnium zirconium oxide layer (2).

9. A method of forming the ferroelectric device (1, 10) of any of the previous claims, the method comprising:
i) providing an intermediate in the formation of the ferroelectric device (1, 10) comprising:
the hafnium zirconium oxide layer (2), doped with a redox-active dopant and comprising a tetragonal phase, and
a metal oxide layer (3), comprising an oxide of a redox-active metal, in physical contact with the hafnium zirconium oxide layer (2),
wherein the dopant and the metal form a redox pair, then
ii) inducing a reduction of the metal of the metal oxide layer (3), so as to transfer oxygen from the metal oxide layer (3) into the hafnium zirconium oxide layer (2), thereby converting at least part of said tetragonal phase into an orthorhombic phase.

10. The method of claim 9, wherein step ii comprises applying a thermal treatment to the metal oxide layer (3).

11. The method of claim 9 or 10, wherein step ii comprises applying a voltage to the metal oxide layer (3).

12. The method of any of claims 9 to 11, wherein the metal oxide layer (3) is provided by depositing the metal oxide layer directly by atomic layer deposition, or
wherein the metal oxide layer (3) is provided by:
depositing the metal (30) by physical vapor deposition, then applying an oxidizing plasma so as to oxidize the deposited metal.

13. The method of any of claims 9 to 12, wherein providing the hafnium zirconium oxide layer (2) doped with a dopant comprises performing atomic layer deposition.

14. An intermediate in the formation of a ferroelectric device (1, 10) comprising:
a hafnium zirconium oxide layer (2), doped with a redox-active dopant and comprising a tetragonal phase, and
a metal oxide layer (3), comprising an oxide of a redox-active metal, in physical contact with the hafnium zirconium oxide layer (2),
wherein the dopant and the metal form a redox pair.

15. A non-volatile memory device (8) comprising a memory cell array,
wherein at least one memory cell in the memory cell array comprises a ferroelectric device (1, 10) according to any one of claims 1 to 8.
